# EUROPEAN PATENT APPLICATION

(11) **EP 4 693 774 A1**
(43) Date of publication of application: **11.02.2026**
(21) Application number: 24795563.6
(22) Date of filing: 23.02.2024
(51) Int. Cl.: H01S 5/50, H01S 5/04

(54) **OPTICAL AMPLIFIER, RELATED METHOD AND DEVICE**

(30) Priority: 28.04.2023 CN 202310488504
(71) Applicant: Huawei Technologies Co., Ltd., Shenzhen, Guangdong 518129 (CN)
(72) Inventor: FAN, Pingjie, Shenzhen, Guangdong 518129 (CN); CHEN, Jie, Shenzhen, Guangdong 518129 (CN); WANG, Shenze, Shenzhen, Guangdong 518129 (CN)
(74) Representative: Isarpatent
(86) International application number: PCT/CN2024/078303
(87) International publication number: WO 2024/222175

(57) **Abstract**

Embodiments of this application disclose an optical amplifier, a related method, and a device, to reduce a nonlinear penalty of a lumped gain medium, increase equivalent incident power, and alleviate a noise figure of the optical amplifier. The optical amplifier provided in embodiments of this application includes a lumped gain medium, configured to: amplify an input optical signal of the optical amplifier to obtain a target optical signal, and output the target optical signal to a first multiplexer/demultiplexer; a first Raman pump unit, configured to: emit first Raman pump light, and output the first Raman pump light to the first multiplexer/demultiplexer, where the first Raman pump light is used to amplify the target optical signal; and the first multiplexer/demultiplexer, configured to couple the target optical signal and the first Raman pump light, to obtain output light of the optical amplifier.

## Description

This application claims priority to Chinese Patent Application No. CN202310488504. 1, filed with the China National Intellectual Property Administration on April 28, 2023 and entitled "OPTICAL AMPLIFIER, RELATED METHOD, AND DEVICE", which is incorporated herein by reference in its entirety.

### TECHNICAL FIELD

Embodiments of this application relate to the field of optical communication, and in particular, to an optical amplifier, a related method, and a device.

### BACKGROUND

A gain medium in an optical amplifier is configured to amplify signal light, and different gain media have different advantages. For example, a distributed gain medium has a wider gain band and a lower noise figure, and a lumped gain medium has a larger gain.

Therefore, different types of gain media may be combined to achieve a combination of a plurality of advantages. A frequently-used structure is to use a distributed gain medium as a first-level gain medium, and use a lumped gain medium as a second-level gain medium to obtain a hybrid optical amplifier, so as to amplify optical signals in sequence.

However, in this optical amplifier structure, the lumped gain medium has high output power. If the output power of the lumped gain medium is higher than saturated output power of the lumped gain medium, a nonlinear penalty such as nonlinear noise is generated, affecting performance of the optical amplifier.

### SUMMARY

Embodiments of this application provide an optical amplifier, a related method, and a device. A Raman pump unit is connected to a downstream of a lumped gain medium, so that a nonlinear penalty of the lumped gain medium is reduced, thereby increasing equivalent incident power and alleviating a noise figure of the optical amplifier.

According to a first aspect, an embodiment of this application provides an optical amplifier. The optical amplifier includes a lumped gain medium, a first Raman pump unit, and a first multiplexer/demultiplexer. The lumped gain medium is configured to: amplify an input optical signal of the optical amplifier to obtain a target optical signal, and output the target optical signal to the first multiplexer/demultiplexer. The first Raman pump unit is configured to: emit first Raman pump light, and output the first Raman pump light to the first multiplexer/demultiplexer, where the first Raman pump light is used to amplify the target optical signal. The first multiplexer/demultiplexer is configured to couple the target optical signal and the first Raman pump light, to obtain output light of the optical amplifier.

In this embodiment of this application, a Raman pump unit is connected to a downstream of the lumped gain medium in the optical amplifier. Therefore, in a downstream fiber of the optical amplifier, the first Raman pump light emitted by the Raman pump unit is used to amplify a signal. In a case of a same overall gain, the Raman pump unit is placed behind the lumped gain medium, so that output optical power of the lumped gain medium can be reduced, thereby reducing a nonlinear penalty of the lumped gain medium and improving performance of the optical amplifier.

In this embodiment of this application, an optical signal output by the optical amplifier not only includes the target optical signal amplified by the lumped gain medium, but also includes the first Raman pump light. Because the first Raman pump light can be used to amplify an optical signal in the downstream fiber, the first Raman pump light is equivalent to increasing optical power of the optical signal of the optical amplifier entering the downstream fiber, which is referred to as incident power in this embodiment of this application.

In an optional implementation, the optical amplifier further includes a control unit. The control unit is configured to: set the lumped gain medium to be in an output optical power locking mode, and set output optical power of the lumped medium to first power, where the first power is less than or equal to saturated output power of the lumped gain medium; control the first Raman pump unit to be turned on, so that the first Raman pump unit emits the first Raman pump light; and lock a gain of the lumped gain medium to a current gain if a target condition is met. The target condition includes: All Raman light sources from a previous relay node of the optical amplifier to the optical amplifier have been turned on.

In this embodiment of this application, in a process of adjusting a gain of the optical amplifier, gain adjustment may occur on an upstream optical path of the lumped gain medium. The control unit locks the output optical power of the lumped gain medium, so that the output optical power of the lumped gain medium is always maintained below the saturated output power of the lumped gain medium regardless of upstream adjustment. Therefore, in an upstream gain adjustment process, a nonlinear penalty of the lumped gain medium is maintained at a low level.

In an optional implementation, the optical amplifier further includes a second Raman pump unit. The second Raman pump unit is configured to emit second Raman pump light, where the second Raman pump light is used to amplify an upstream optical signal of the optical amplifier, to obtain the input optical signal of the optical amplifier.

In this embodiment of this application, in the optical amplifier, the second Raman pump unit is connected to an upstream of the lumped gain medium, so that input optical power of the lumped gain medium can be increased, thereby increasing an optical signal-to-noise ratio (optical signal-to-noise ratio, OSNR) of the whole amplifier.

In an optional implementation, the optical amplifier includes a target pump array; and both a light source of the first Raman pump unit and a light source of the second Raman pump unit are the target pump array.

In this embodiment of this application, the first Raman pump unit and the second Raman pump unit share the target pump array. In some scenarios, pump power of the first Raman pump unit may be low (where a small quantity of pump light sources are required) and pump power of the second Raman pump unit may be high (where a large quantity of pump light sources are required). In some other scenarios, the pump power of the first Raman pump unit may be high and the pump power of the second Raman pump unit may be low. In different scenarios, the target pump array provides pump light sources for the two Raman pump units, so that corresponding quantities of pump light sources can be flexibly allocated to the two pump units, thereby reducing a total quantity of pump light sources (pump lasers) in the optical amplifier, and improving reliability of a structure of the optical amplifier.

In an optional implementation, the lumped gain medium includes a semiconductor optical amplifier SOA or a gain medium doped with a rare earth element.

According to a second aspect, an embodiment of this application provides an optical communication device. The optical communication device includes the optical amplifier according to the first aspect.

According to a third aspect, an embodiment of this application provides an optical communication system. The optical communication system includes the optical amplifier according to the first aspect.

According to a fourth aspect, an embodiment of this application provides a gain adjustment method. The method is applied to an optical amplifier. The optical amplifier includes a lumped gain medium, a first Raman pump unit, and a first multiplexer/demultiplexer. The first multiplexer/demultiplexer is configured to: couple a target optical signal amplified by the lumped gain medium and first Raman pump light emitted by the first Raman pump unit for output from the optical amplifier. The method includes: setting the lumped gain medium to be in an output optical power locking mode, and setting output optical power of the lumped gain medium to first power, where the first power is less than or equal to saturated output power of the lumped gain medium; turning on the first Raman pump unit to emit the first Raman pump light; and locking a gain of the lumped gain medium to a current gain if a target condition is met. The target condition includes: All Raman light sources from a previous relay node of the optical amplifier to the optical amplifier have been turned on.

Optionally, the method may be applied to the optical amplifier according to the first aspect, or the control unit in the optical amplifier according to the first aspect.

In this embodiment of this application, in a process of adjusting a gain of the optical amplifier, gain adjustment may occur on an upstream optical path of the lumped gain medium. Before the target condition is met, the lumped gain medium is set to be in the output power locking mode. Therefore, the output optical power of the lumped gain medium is always maintained below the saturated output power of the lumped gain medium regardless of upstream adjustment of the lumped gain medium. Therefore, in an upstream gain adjustment process, a nonlinear penalty of the lumped gain medium may be maintained at a low level.

In an optional implementation, the action of turning on the first Raman pump unit to emit the first Raman pump light may specifically include: determining first pump power of the first Raman pump unit, where the first pump power is less than target power, the target power is minimum pump power that causes an optical signal to generate nonlinear noise on a target link, and the target link is a link between the optical amplifier and a next optical amplifier of the optical amplifier; and turning on the first Raman pump unit to emit the first Raman pump light at the first pump power.

In this embodiment of this application, the pump power of the first Raman pump unit is less than the target power, so that nonlinear noise generated by the first Raman pump light can be reduced on a downstream optical path (that is, the target link) of the first Raman pump unit, thereby improving signal transmission performance on a downstream of the optical amplifier.

In an optional implementation, the optical amplifier further includes a second Raman pump unit; and after turning on the first Raman pump unit, the method further includes: if power of an input optical signal of the optical amplifier is less than a first threshold, turning on the second Raman pump unit to emit second Raman pump light, where the second Raman pump light is used to amplify an upstream optical signal of the optical amplifier, to increase the power of the input optical signal of the optical amplifier.

In this embodiment of this application, in the optical amplifier, the second Raman pump unit connected to an upstream of the lumped gain medium is turned on, so that input optical power of the lumped gain medium can be increased, thereby increasing an optical signal-to-noise ratio OSNR of the whole amplifier.

In an optional implementation, the action of turning on the second Raman pump unit to emit the second Raman pump light may specifically include: determining a target gain of the second Raman pump unit, where the target gain is a difference between saturated pump power of the second Raman pump unit and the power of the input optical signal of the optical amplifier; and turning on the second Raman pump unit, setting the second Raman pump unit to be in a gain locking mode, and setting a gain value of the second Raman pump unit to the target gain, to emit the second Raman pump light based on the target gain.

In this embodiment of this application, the gain of the second Raman pump unit is locked to be the difference between the saturated pump power of the second Raman pump unit and the power of the input optical signal, so that optical power of a signal can be increased as much as possible on a premise of low nonlinear noise (where power at a second Raman pump is not greater than the saturated pump power).

In an optional implementation, locking the gain of the lumped gain medium to the current gain if the target condition is met may specifically include: after turning on the second Raman pump unit, locking the gain of the lumped gain medium to the current gain if the target condition is met.

In this embodiment of this application, the output optical power of the lumped gain medium may be increased when the second Raman pump unit is turned on. Therefore, before the second Raman pump unit is turned on, the gain of the lumped gain medium is not locked, but the output optical power of the lumped gain medium is locked. This can prevent nonlinear noise caused by the output optical power of the lumped gain medium being greater than the saturated output power due to turn-on of the second Raman pump unit.

According to a fifth aspect, an embodiment of this application provides a computer device. The computer device includes a processor, a memory, and a bus. The processor and the memory are connected to the bus. The processor is configured to perform the gain adjustment method according to the fourth aspect.

According to a sixth aspect, an embodiment of this application provides a computer-readable storage medium. The computer-readable storage medium stores a program, and when a computer executes the program, the gain adjustment method according to the fourth aspect is performed.

According to a seventh aspect, an embodiment of this application provides a computer program product. When the computer program product is executed on a computer, the computer performs the gain adjustment method according to the fourth aspect.

### BRIEF DESCRIPTION OF DRAWINGS

FIG. 1 is a diagram of a structure of an optical communication system according to this application;
FIG. 2 is a diagram of a structure of an optical amplifier according to an embodiment of this application;
FIG. 3 is a diagram of evolution of signal power with a length of an optical fiber according to an embodiment of this application;
FIG. 4 is a diagram of a structure of an optical amplifier including a second Raman pump unit according to an embodiment of this application;
FIG. 5a is a diagram of a receive-end power spectrum according to an embodiment of this application;
FIG. 5b is a diagram of an optical amplifier NF spectrum according to an embodiment of this application;
FIG. 6 is a diagram of a gain adjustment method according to an embodiment of this application;
FIG. 7 is a diagram of a structure of an optical amplifier according to an embodiment of this application;
FIG. 8A and FIG. 8B are a diagram of a structure of a multi-span optical amplifier according to an embodiment of this application;
FIG. 9 is a schematic flowchart of a gain adjustment method according to an embodiment of this application;
FIG. 10 is a diagram of power changes of a multi-span fiber according to an embodiment of this application; and
FIG. 11 is a diagram of another structure of an optical amplifier according to an embodiment of this application.

### DESCRIPTION OF EMBODIMENTS

The following describes embodiments of this application with reference to the accompanying drawings. A person of ordinary skill in the art may learn that, with development of technologies and emergence of new scenarios, the technical solutions provided in embodiments of this application are also applicable to a similar technical problem.

In the specification, claims, and accompanying drawings of this application, the terms "first", "second", and the like are intended to distinguish between similar objects but do not necessarily indicate a specific order or sequence. It should be understood that the terms used in such a way are interchangeable in proper circumstances. This is merely a discrimination manner that is used when objects having a same attribute are described in embodiments of this application. In addition, the terms "include", "have", and any other variants are intended to cover a non-exclusive inclusion, so that a process, a method, a system, a product, or a device that includes a series of units is not necessarily limited to those units, but may include other units not expressly listed or inherent to the process, the method, the product, or the device. In addition, "at least one" means one or more, and "a plurality of" means two or more. "And/or" describes an association relationship between associated objects, and represents that three relationships may exist. For example, A and/or B may represent: Only A exists, both A and B exist, and only B exists, where A and B may be singular or plural. The character "/" generally indicates an "or" relationship between the associated objects. "At least one of the following items (pieces)" or a similar expression thereof means any combination of these items, including a singular item (piece) or any combination of plural items (pieces). For example, at least one of a, b, or c may indicate: a, b, c, a and b, a and c, b and c, or a, b, and c, where a, b, and c may be singular or plural.

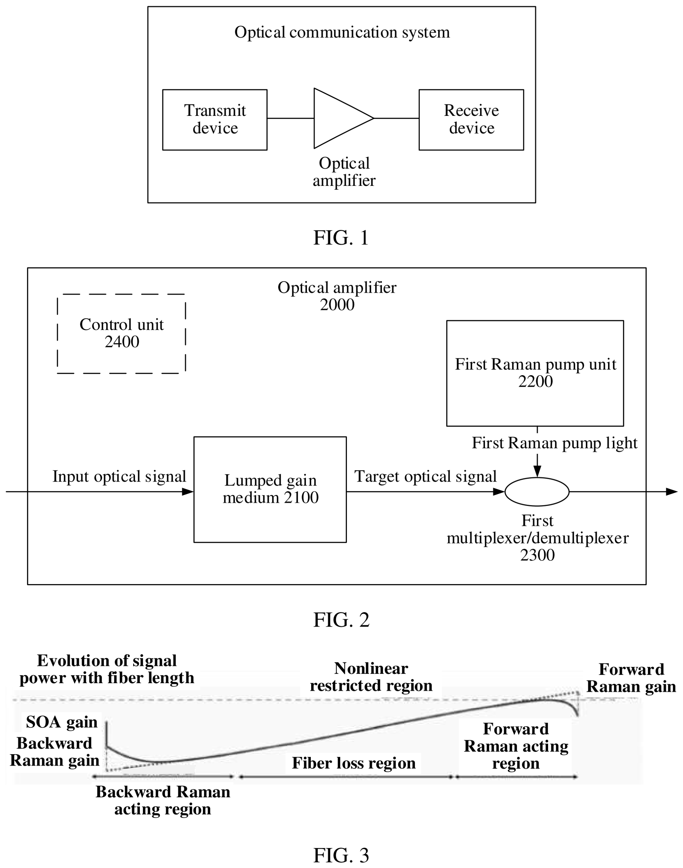

FIG. 1 is a diagram of a structure of an optical communication system. The optical communication system includes a transmit device, a receive device, and a fiber. The transmit device is configured to perform electro-optic modulation, to carry a signal in an optical signal and input the optical signal into the fiber for transmission. The fiber is configured to transmit the optical signal. The receive device is configured to receive and parse the optical signal.

As shown in FIG. 1, the optical communication system may further include an optical amplifier. The optical amplifier is located between the transmit device and the receive device, and is configured to compensate for a fiber span loss. Therefore, signal attenuation and distortion are reduced, and the signal transmission reliability and transmission quality are improved.

A gain medium in the optical amplifier is configured to amplify signal light, and different gain media have different advantages. For example, a distributed gain medium has a wider gain band and a lower noise figure, and a lumped gain medium has a larger gain.

Therefore, different types of gain media may be combined to achieve a combination of a plurality of advantages. A frequently-used structure is to use a distributed gain medium as a first-level gain medium, and use a lumped gain medium as a second-level gain medium to obtain a hybrid optical amplifier, so as to amplify optical signals in sequence.

When high-energy photons (an optical signal) pass through the lumped gain medium, the high-energy photons interact with particles such as atoms, ions, or molecules in the gain medium. As a result, an internal state of the gain medium is changed, and an optical property of the gain medium is affected. If power of the optical signal is greater than or equal to saturated output power of the gain medium, the interaction will cause nonlinear behavior such as a frequency mixing effect between optical waves of different frequencies and phase modulation. The foregoing effect or behavior causes nonlinear distortion in propagation and amplification of an optical field, affecting stability and precision of signal transmission and amplification. This phenomenon is referred to as a nonlinear penalty of the gain medium.

In this optical amplifier structure, the lumped gain medium is used as a second-level optical amplifier, and has high output power. If the output power of the lumped gain medium is greater than saturated output power of the lumped gain medium, a nonlinear penalty such as nonlinear noise is generated, leading to a high nonlinear penalty of the lumped gain medium and affecting performance of the optical amplifier.

To resolve the foregoing problems, embodiments of this application provide an optical amplifier, a related method, and a device. The optical amplifier is a hybrid optical amplifier, and a Raman pump unit is connected to a downstream of a lumped gain medium to reduce output optical power of the lumped gain medium, thereby reducing a nonlinear penalty of the lumped gain medium, increasing equivalent incident power, and alleviating a noise figure of the optical amplifier.

As shown in FIG. 2, an optical amplifier 2000 provided in an embodiment of this application includes a lumped gain medium 2100, a first Raman pump unit 2200, and a first multiplexer/demultiplexer 2300. The lumped gain medium 2100 is configured to: amplify an input optical signal of the optical amplifier to obtain a target optical signal, and output the target optical signal to the first multiplexer/demultiplexer 2300.

The first Raman pump unit 2200 is a forward Raman pump unit of the lumped gain medium 2100. The first Raman pump unit 2200 is configured to: emit first Raman pump light, and output the first Raman pump light to the first multiplexer/demultiplexer 2300.

The first multiplexer/demultiplexer 2300 includes a plurality of branch ports and one common port. One branch port of the first multiplexer/demultiplexer 2300 is connected to an output end of the lumped gain medium 2100, and one branch port is connected to the first Raman pump unit 2200. The common port of the first multiplexer/demultiplexer 2300 is connected to an output port of the optical amplifier 2000. The first multiplexer/demultiplexer 2300 is configured to: couple the target optical signal and the first Raman pump light, to obtain output light of the optical amplifier 2000; and output the output light to the output port of the optical amplifier 2000, to output the output light from the optical amplifier 2000.

The first Raman pump light is used to amplify the target optical signal in a downstream fiber connected to the optical amplifier 2000.

In this embodiment of this application, the first Raman pump unit 2200 is connected to a downstream of the lumped gain medium 2100 in the optical amplifier 2000. Therefore, in the downstream fiber of the optical amplifier 2000, the first Raman pump light emitted by the first Raman pump unit 2200 is used to amplify a signal. In a case of a same overall gain, the first Raman pump unit 2200 is placed behind the lumped gain medium 2100, so that output optical power of the lumped gain medium 2100 can be reduced, thereby reducing a nonlinear penalty of the lumped gain medium 2100 and improving performance of the optical amplifier 2000.

In this embodiment of this application, an optical signal output by the optical amplifier 2000 not only includes the target optical signal amplified by the lumped gain medium 2100, but also includes the first Raman pump light. Because the first Raman pump light can be used to amplify an optical signal in the downstream fiber of the optical amplifier 2000, the first Raman pump light is equivalent to increasing optical power of the optical signal of the optical amplifier 2000 entering the downstream fiber, which is referred to as incident power in this embodiment of this application.

In this embodiment of this application, all optical power other than specially mentioned pump light power is optical power of an optical signal in a communication band.

In this embodiment of this application, because the first Raman pump unit 2200 is located in a forward direction of signal transmission of the lumped gain medium 2100, the first Raman pump unit 2200 is also referred to as a forward Raman pump unit.

Optionally, in a structure shown in FIG. 2, the lumped gain medium 2100 and the first Raman pump unit 2200 may have amplification capabilities in a wide band. Therefore, the optical amplifier 2000 can be used in a network with a wide transmission band. For example, the lumped gain medium 2100 and the first Raman pump unit 2200 may support amplification of an optical signal with a wavelength width of 70 nm.

Optionally, the optical amplifier 2000 shown in FIG. 2 may further include a control unit 2400. The control unit 2400 is configured to: set the lumped gain medium 2100 to be in an output optical power locking mode, and set output optical power of the lumped medium 2100 to first power, where the first power is less than or equal to saturated output power of the lumped gain medium 2100.

The control unit 2400 is further configured to control the first Raman pump unit 2200 to be turned on, so that the first Raman pump unit 2200 emits the first Raman pump light.

The control unit 2400 locks a gain of the lumped gain medium 2100 to a current gain if a target condition is met. The target condition includes: All Raman light sources from a previous relay node of the optical amplifier 2000 to the optical amplifier 2000 have been turned on.

In this embodiment of this application, in a process of adjusting a gain of the optical amplifier 2000, gain adjustment may occur on an upstream optical path of the lumped gain medium 2100. The control unit 2400 locks the output optical power of the lumped gain medium 2100, so that the output optical power of the lumped gain medium 2100 is always maintained below the saturated output power (the first power) of the lumped gain medium 2100 regardless of upstream adjustment. Therefore, in an upstream gain adjustment process, the nonlinear penalty of the lumped gain medium 2100 is maintained at a low level.

Optionally, the optical amplifier 2000 may be a board on an optical relay station. The control unit 2400 may be a controller on the board, and is configured to control the lumped gain medium 2100 and the first Raman pump unit 2200. Optionally, the optical amplifier 2000 further includes a dedicated control module of the lumped gain medium 2100 and a dedicated control module of the first Raman pump unit 2200, and the control unit 2400 may include the dedicated control modules of the components.

In the optical amplifier 2000 shown in FIG. 2, changes of power of an optical signal with a fiber length are shown in FIG. 3. If the optical amplifier 2000 does not include forward Raman (the first Raman pump unit 2200) or backward Raman (a second Raman pump unit 2500), a corresponding change curve is shown by a dotted line in the figure. For a forward direction of the optical amplifier 2000 (that is, a downstream of the optical amplifier 2000), due to existence of the downstream fiber, the power of the optical signal is reduced, and therefore, output optical power of an SOA (the lumped gain medium 2100) needs to be increased. As shown by a dashed line in an upper part in the figure, the output optical power may be greater than a nonlinear restricted region (that is, the saturated output power) of the lumped gain medium 2100, leading to a high nonlinear penalty of the lumped gain medium 2100.

In the optical amplifier 2000 provided in this embodiment of this application, the first Raman pump light emitted by the forward Raman (the first Raman pump unit 2200) implements amplification of an optical signal in the downstream fiber of the optical amplifier 2000. This is equivalent to equivalently increasing incident power of an optical signal of the SOA entering the downstream fiber (equivalent to an oblique dotted line in the upper part in the figure). This ensures that output power of the SOA is lower than the saturated output power (in the nonlinear restricted region), and also ensures transmission performance of a downstream optical signal.

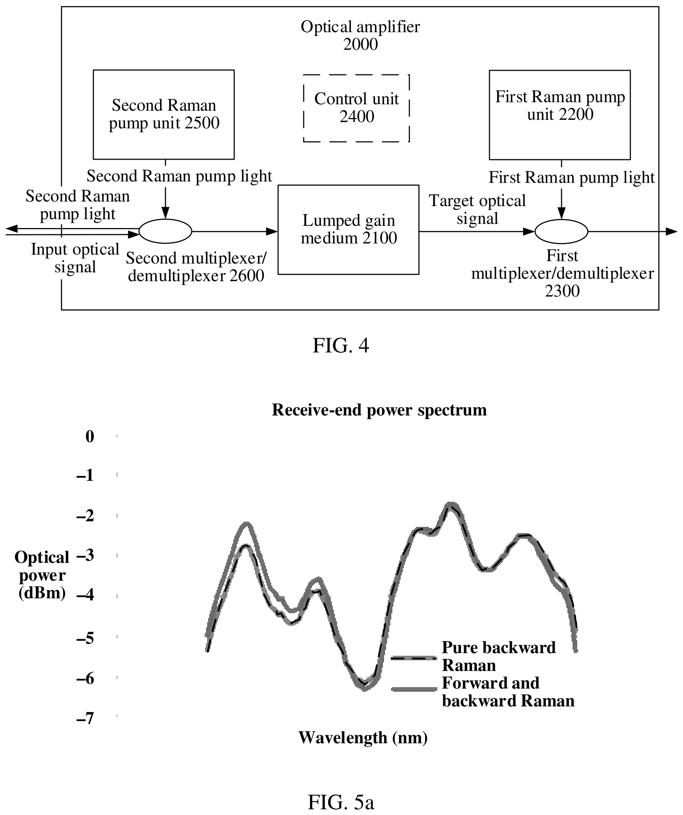

Optionally, as shown in FIG. 4, the optical amplifier 2000 may further include the second Raman pump unit 2500 and a second multiplexer/demultiplexer 2600. The second Raman pump unit 2500 is configured to emit second Raman pump light. The second multiplexer/demultiplexer 2600 is configured to output the second Raman pump light to an input port of the optical amplifier 2000, to output the second Raman pump light to an upstream fiber of the optical amplifier 2000. The second Raman pump light is used to amplify an upstream optical signal of the optical amplifier in the upstream fiber, to obtain the input optical signal of the optical amplifier. The second multiplexer/demultiplexer 2600 is further configured to transmit the input optical signal of the optical amplifier 2000 to the lumped gain medium 2100.

In this embodiment of this application, in the optical amplifier 2000, the second Raman pump unit 2500 is connected to an upstream of the lumped gain medium 2100, so that the upstream optical signal can be amplified by using the second Raman pump light emitted by the second Raman pump unit 2500. Because a noise figure of the second Raman pump unit 2500 is low, a noise figure of the whole amplifier may be alleviated.

In this embodiment of this application, because the second Raman pump unit 2500 is located in a backward direction of signal transmission of the lumped gain medium 2100, the second Raman pump unit 2500 is also referred to as a backward Raman pump unit.

Optionally, in this structure, the control unit 2400 may be further configured to control the second Raman pump unit 2500. Optionally, the optical amplifier 2000 further includes a dedicated control module of the second Raman pump unit 2500, and the control unit 2400 may include the dedicated control module.

Optionally, the forward first Raman pump unit 2200 and the backward second Raman pump unit 2500 are adjusted and controlled independently of each other, and do not affect each other. The two Raman pump units may be in a physically centralized form, or may be different boards in a separate form. This is not limited in this application. If the two Raman pump units are different boards in a separate form, whether to use the second Raman pump unit 2500 may be determined in a design process of an optical communication system. Therefore, the different boards in the separated form can adapt to different systems.

Optionally, the lumped gain medium 2100 may be a semiconductor optical amplifier SOA, a gain medium doped with a rare earth element, or the like. This is not limited in this application.

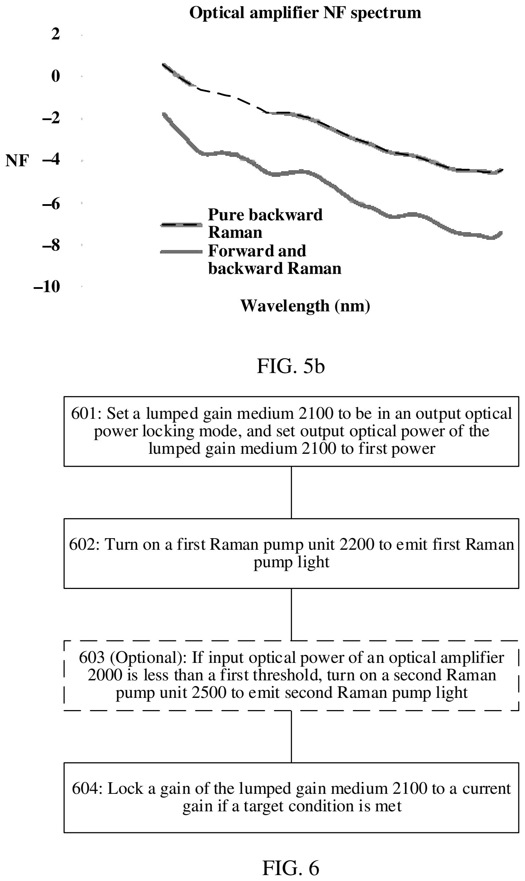

Simulation tests are performed on the structure shown in FIG. 4, and results shown in FIG. 5a and FIG. 5b may be obtained. In FIG. 5a and FIG. 5b, a dashed line represents a conventional hybrid optical amplifier (a backward Raman pump+the SOA), and a solid line represents the optical amplifier 2000 (a backward Raman pump+the SOA+a forward Raman pump) provided in this embodiment of this application. As shown in FIG. 5a, when the forward Raman (the first Raman pump unit 2200) is turned on, pump power of the backward Raman (the second Raman pump unit 2500) is adjusted, so that output power of the backward Raman remains unchanged (in other words, a receive-end power spectrum remains unchanged). An optical amplifier NF is measured separately when the forward Raman is turned on and turned off. As shown in FIG. 5b, compared with an NF of conventional pure backward Raman, an NF of the structure with the forward and backward Raman provided in this embodiment of this application is reduced by 2 dB+, and a single-span OSNR gain is approximately 2 dB.

Based on the structure of the optical amplifier 2000 shown in FIG. 2 and FIG. 4, an embodiment of this application further provides a gain adjustment method. The method may be specifically applied to the control unit 2400 in the embodiment shown in FIG. 2 or FIG. 4. As shown in FIG. 6, the method includes the following steps.

601: Set a lumped gain medium 2100 to be in an output optical power locking mode, and set output optical power of the lumped gain medium 2100 to first power.

In this embodiment of this application, in a process of adjusting a gain of the optical amplifier, gain adjustment may occur on an upstream optical path of the lumped gain medium, affecting the output optical power of the lumped gain medium 2100. To prevent the output optical power of the lumped gain medium 2100 from being greater than saturated output power, the control unit 2400 may set the lumped gain medium to be in the output power locking mode, and set the output optical power of the lumped gain medium 2100 to the first power. The first power is less than or equal to the saturated output power of the lumped gain medium 2100.

After the lumped gain medium 2100 is set to be in the output power locking mode, the output optical power of the lumped gain medium 2100 is always maintained below the saturated output power of the lumped gain medium regardless of upstream gain adjustment of the lumped gain medium 2100. Therefore, in an upstream gain adjustment process, a nonlinear penalty of the lumped gain medium 2100 may be maintained at a low level.

602: Turn on a first Raman pump unit 2200 to emit first Raman pump light.

To increase transmission power of an optical signal on a downstream of the optical amplifier 2000, the control unit 2400 may turn on the first Raman pump unit 2200 to emit the first Raman pump light. The first Raman pump light may amplify the optical signal in a downstream fiber of the optical amplifier 2000.

Optionally, to prevent the optical signal from generating nonlinear noise in the downstream fiber of the optical amplifier 2000, the control unit 2400 may determine first pump power of the first Raman pump unit; and turn on the first Raman pump unit to emit the first Raman pump light at the first pump power.

The first pump power is less than target power. The target power is minimum pump power that causes an optical signal to generate nonlinear noise on a target link. The target link is a link between the optical amplifier and a next optical amplifier of the optical amplifier, and includes the downstream fiber of the optical amplifier 2000.

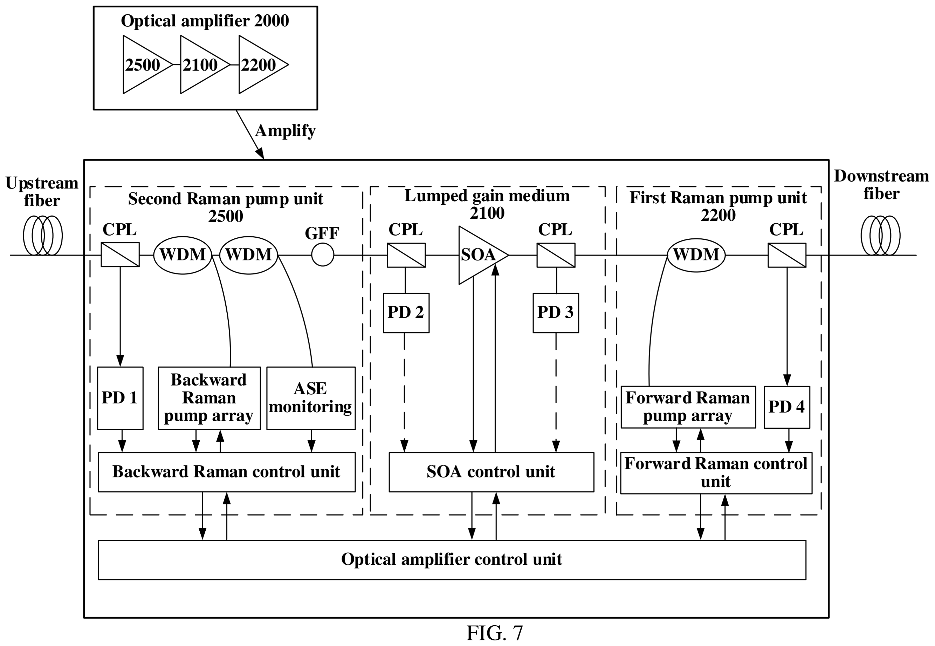

Optionally, the control unit 2400 may determine the first pump power in a manner such as table lookup. A corresponding structure of the optical amplifier 2000 is shown in FIG. 7.

A second Raman pump unit 2500 includes a PD 1, a backward Raman pump array, an out-of-band ASE monitoring unit, a GFF, and a backward Raman control unit. The PD 1 is configured to report output power.

The lumped gain medium 2100 includes an SOA chip, a PD 2, a PD 3, and an SOA control unit. The SOA chip is a gain medium, and the PD 2 and the PD 3 are respectively configured to detect power of SOA bilateral signals and report the power to the SOA control unit.

The first Raman pump unit 2200 includes a PD 4, a forward Raman pump array, and a forward Raman control unit. The PD 4 is configured to report incident power (that is, output power of the optical amplifier 2000) to a forward Raman power unit. The forward Raman power unit may obtain a delivered pump current value by querying Table 1.

It should be noted that, the forward Raman control unit, the SOA control unit, the backward Raman control unit, and an optical amplifier control unit in FIG. 7 are all included in the foregoing control unit 2400.

For example, the control unit 2400 may determine the corresponding first pump power P(x, y) based on a correspondence shown in Table 1, a code pattern of the optical signal, a type of the downstream fiber, input optical power Pin(y) of the first Raman pump unit 2200 (that is, power at the PD 3), and an average loss Att(x) of the downstream fiber. 1≤x≤m, and 1≤y≤n.

**Table 1 Mapping table of the first pump power**

| Code pattern | 200G QPSK | | Fiber type | G.652 | |
|---|---|---|---|---|---|
| Average fiber loss (db/km) | Incident power (dB) | | | | |
| | Pin(1) | Pin(2) | Pin(3) | ... | Pin(n) |
| Att(1) | P(1, 1) | P(1, 2) | P(1, 3) | XXX | P(1, n) |
| Att(2) | P(2, 1) | | | | |
| Att(3) | | | | | |
| ... | | | | | |
| Att(m) | P(m, 1) | | | | P(m, n) |

In this embodiment of this application, the pump power of the first Raman pump unit is less than the target power, so that nonlinear noise generated by the first Raman pump light can be reduced on a downstream optical path (that is, the target link) of the first Raman pump unit, thereby improving signal transmission performance on the downstream of the optical amplifier 2000.

603 (Optional): If input optical power of the optical amplifier 2000 is less than a first threshold, turn on the second Raman pump unit 2500 to emit second Raman pump light.

If the optical amplifier 2000 includes the second Raman pump unit 2500, whether to turn on the second Raman pump unit 2500 may be determined based on the input optical power of the optical amplifier.

Optionally, if power of an input optical signal of the optical amplifier is less than the first threshold, the control unit 2400 turns on the second Raman pump unit 2500 to emit the second Raman pump light. The second Raman pump light is used to amplify an upstream optical signal of the optical amplifier 2000, to increase the power of the input optical signal of the optical amplifier 2000.

In this embodiment of this application, in the optical amplifier, the second Raman pump unit connected to the upstream of the lumped gain medium is turned on, so that input optical power of the lumped gain medium can be increased, thereby increasing an optical signal-to-noise ratio OSNR of the whole amplifier.

Optionally, the control unit 2400 may determine a target gain of the second Raman pump unit 2500, where the target gain is a difference between saturated pump power of the second Raman pump unit 2500 and the power of the input optical signal of the optical amplifier 2000. Then, the control unit 2400 may set the second Raman pump unit 2500 to be in a gain locking mode, and set a gain value of the second Raman pump unit 2500 to the target gain, so that the second Raman pump unit 2500 emits the second Raman pump light based on the target gain.

In this embodiment of this application, the gain of the second Raman pump unit 2500 is locked to be the difference between the saturated pump power of the second Raman pump unit 2500 and the power of the input optical signal, so that optical power of a signal can be increased as much as possible on a premise of low nonlinear noise (where power at the second Raman pump unit 2500 is not greater than the saturated pump power).

Optionally, the control unit 2400 may calibrate and record a correspondence between the input optical power Pout(y) of the lumped gain medium 2100 (that is, power at the PD 2), a set gain value G(x) of the optical amplifier 2000, and the target gain ASE(x, y). Therefore, during actual application, the target gain is quickly determined based on the correspondence. 1≤x≤m, and 1≤y≤n.

For example, the control unit 2400 may record the foregoing correspondence in Table 2. During actual application, based on the correspondence shown in Table 2, the corresponding target gain ASE(x, y) is determined based on output optical power Pout(y) of the second Raman pump unit 2500 (that is, the input optical power of the lumped gain medium 2100, which is also the power at the PD 2) and a set gain value G(x) of the second Raman pump unit 2500.

**Table 2 Mapping table of the target gain**

| Gain | Output power (dB) | | | | |
|---|---|---|---|---|---|
| | Pout(1) | Pout(2) | Pout(3) | ... | Pout(n) |
| G(1) | ASE(1, 1) | P(1, 2) | P(1, 3) | XXX | ASE(1, n) |
| G(2) | ASE(2, 1) | | | | |
| G(3) | ASE(3, 1) | | | | |
| ... | | | | | |
| G(m) | ASE(m, 1) | | | XXX | P(m, n) |

Optionally, if the power of the input optical signal of the optical amplifier 2000 is greater than or equal to the first threshold, the second Raman pump unit 2500 is not turned on.

Optionally, if the optical amplifier 2000 does not include the second Raman pump unit 2500, step 603 is not performed.

604: Lock a gain of the lumped gain medium 2100 to a current gain if a target condition is met.

Turn-on of the second Raman pump unit 2500 or another Raman pump unit on an upstream of the optical amplifier 2000 is likely to cause an increase in the output optical power of the lumped gain medium 2100. Therefore, the control unit 2400 may determine, based on determining of the target condition, a moment to lock the gain of the lumped gain medium 2100, to complete gain adjustment of the optical amplifier 2000.

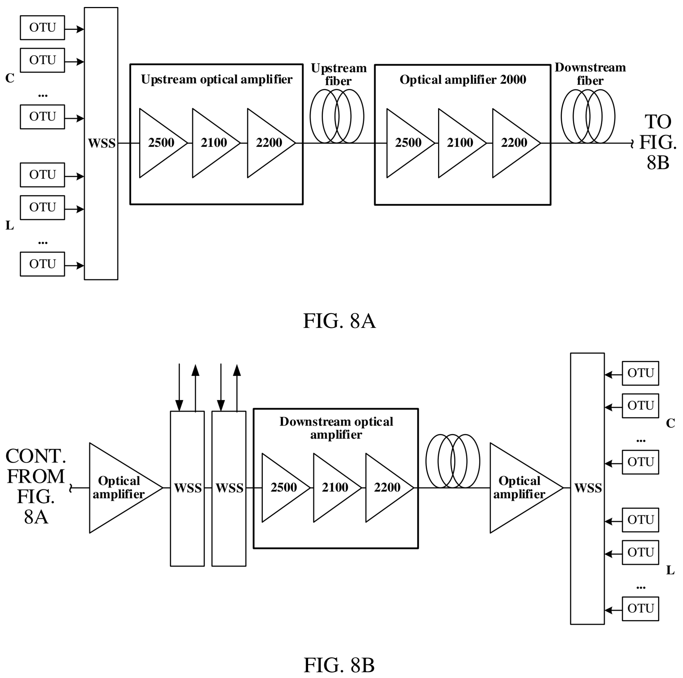

The target condition includes: All Raman light sources from a previous relay node of the optical amplifier 2000 to the optical amplifier 2000 have been turned on. For example, as shown in FIG. 8A and FIG. 8B, the upstream of the optical amplifier 2000 includes an upstream fiber, an upstream optical amplifier, and a relay node (WSS). If all Raman pump light sources from the WSS to the optical amplifier 2000 have been turned on, the control unit 2400 may determine that the target condition is met, and lock the gain of the lumped gain medium 2100 to the current gain, to complete gain adjustment of the optical amplifier 2000.

Optionally, the control unit 2400 may further lock the gain of the lumped gain medium 2100 after turning on the second Raman pump unit 2500 and determining that the target condition is met. Before the second Raman pump unit 2500 is turned on, the gain of the lumped gain medium 2100 is not locked, but the output optical power of the lumped gain medium 2100 is locked. This can prevent nonlinear noise caused by the output optical power of the lumped gain medium 2100 being greater than the saturated output power due to turn-on of the second Raman pump unit 2500.

Optionally, the lumped gain medium 2100 may be an SOA. Optionally, the control unit 2400 may calibrate and record a correspondence between the input optical power Pin(x) of the lumped gain medium 2100 (that is, the power at the PD 2), the output optical power Pout(y) of the lumped gain medium 2100 (that is, the power at the PD 3), and a drive current I(x, y) of the lumped gain medium 2100. Therefore, during actual application, the drive current of the lumped gain medium 2100 is quickly determined based on the correspondence. 1≤x≤m, and 1≤y≤n.

For example, the control unit 2400 may record the foregoing correspondence in Table 3. During actual application (that is, when step 601 is performed), based on the correspondence shown in Table 3, the corresponding drive current of the lumped gain medium 2100 (SOA) is determined based on Pin(x) and Pout(y). Optionally, determining and delivering a drive current value may be specifically implemented by using an SOA control module in FIG. 7.

**Table 3 Mapping table of the drive current of the lumped gain medium 2100**

| Input power | Output power (dB) | | | | |
|---|---|---|---|---|---|
| | Pout(1) | Pout(2) | Pout(3) | ... | Pout(n) |
| Pin(1) | I(1, 1) | I(1, 1) | I(1, 1) | XXX | I(1, n) |
| Pin(2) | I(2, 1) | | | | |
| Pin(3) | I(3, 1) | | | | |
| ... | | | | | |
| Pin(m) | I(m, 1) | | | XXX | I(m, n) |

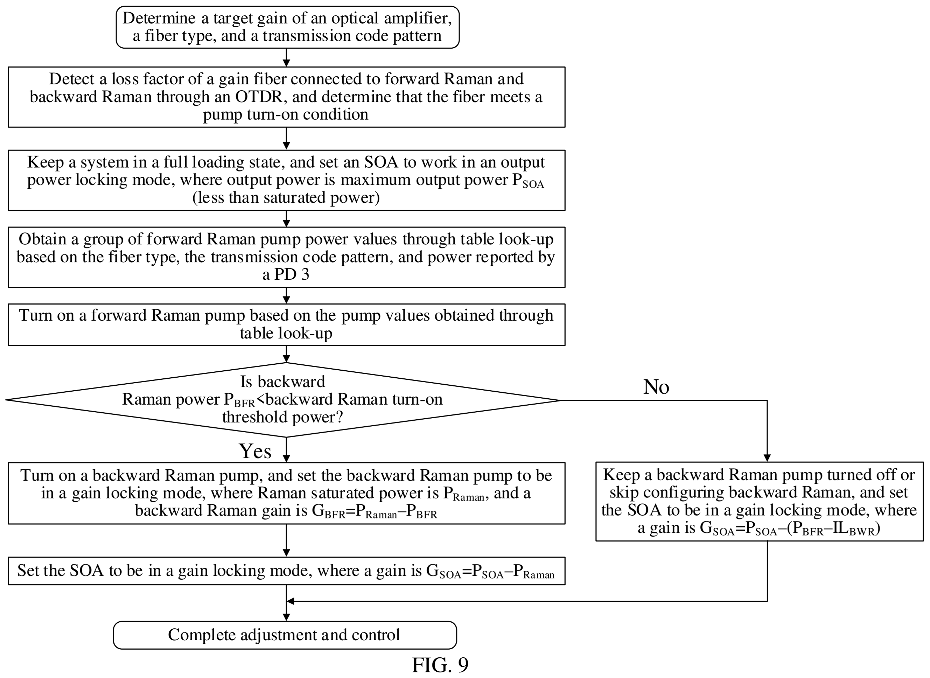

In the embodiment shown in FIG. 6, some necessary steps are omitted between the steps. For a complete procedure, refer to FIG. 9. In FIG. 9, P_{BRF} is input optical power of a backward Raman pump unit (that is, the second Raman pump unit 2500) (also input optical power of the optical amplifier 2000), and backward Raman turn-on threshold power is the foregoing first threshold. G_{BRF} is a gain of the backward Raman pump unit (that is, the second Raman pump unit 2500), and P_{Raman} is Raman saturated power of the second Raman pump unit 2500. G_{SOA} is a gain of the SOA (that is, the lumped gain medium 2100), P_{SOA} is the saturated output power of the lumped gain medium 2100, and IL_{BWR} is an insertion loss of each multiplexer/demultiplexer in the optical amplifier 2000.

Optionally, if the optical amplifier 2000 does not include the second Raman pump unit 2500, a determining action does not need to be performed in FIG. 9. After a forward Raman pump is turned on, the SOA may be set to be in a gain locking mode, where the gain is G_{SOA}=(P_{BRF}-IL_{BWR}), to complete adjustment and control.

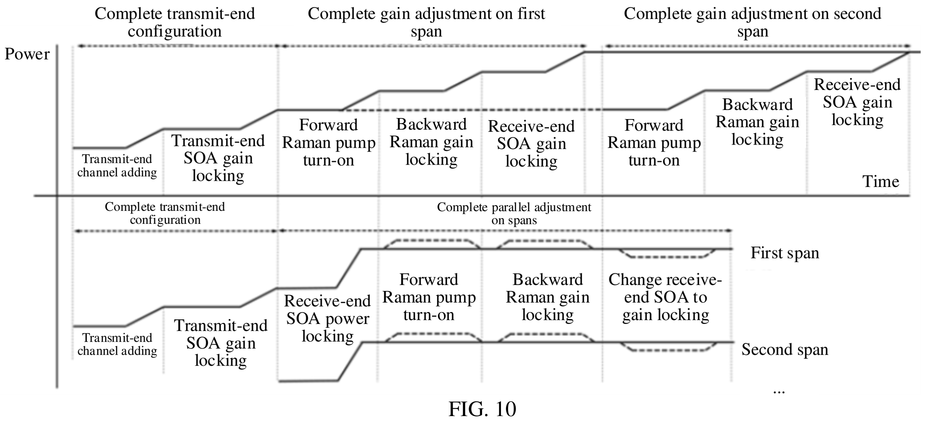

Based on the gain adjustment method provided in this embodiment of this application, simultaneous adjustment and control of multi-span cascaded hybrid optical amplifiers can be further implemented, to reduce service streamlining time. In FIG. 10, a line chart in an upper half part represents a gain adjustment time sequence and optical signal power between spans by using a conventional gain adjustment method, and a line chart in a lower half part represents a gain adjustment time sequence and optical signal power between spans by using the gain adjustment method provided in this embodiment of this application.

As shown in FIG. 10, if gain adjustment is performed in a conventional adjustment manner, because a next span does not know output power of a previous span, deployment adjustment of the span can be performed only after the output power of the previous span is stable.

As shown in FIG. 10, if gain adjustment is performed in an adjustment manner provided in this embodiment of this application, output power of each span can remain unchanged through power locking of the SOA (the lumped gain medium 2100). Raman pump light emitted by a forward Raman pump (the first Raman pump unit 2200) of each span is used to compensate for a power loss of an optical signal on a fiber of the span, so that input power of each span remains unchanged, thereby implementing parallel adjustment on spans (simultaneous commissioning of power of service light on a plurality of spans), and accelerating deployment service streamlining.

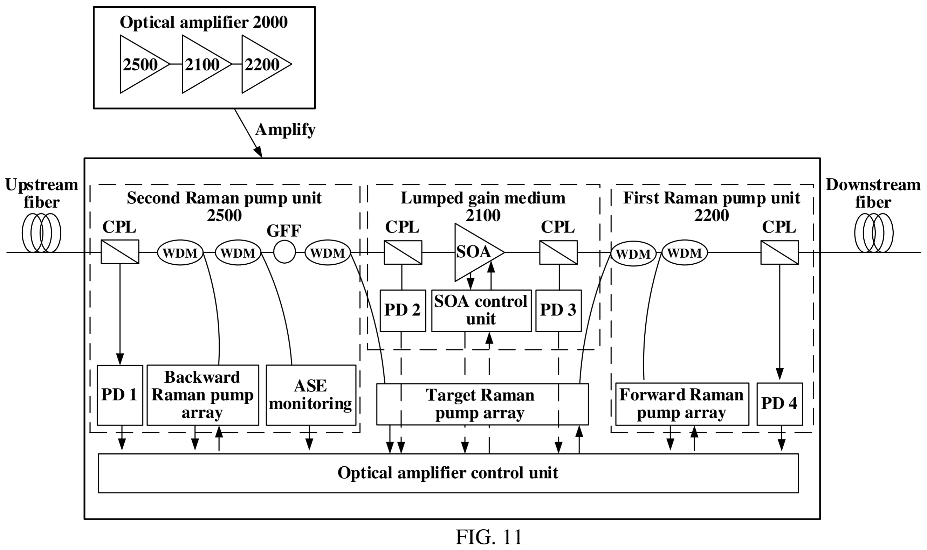

Optionally, in the optical amplifier 2000 shown in FIG. 3, FIG. 7, FIG. 8A, and FIG. 8B, the optical amplifier may include a target pump array. Both a light source of the first Raman pump unit 2200 and a light source of the second Raman pump unit 2500 are the target pump array. For a corresponding structure, refer to FIG. 11.

In this embodiment of this application, the first Raman pump unit 2200 and the second Raman pump unit 2500 share the target pump array. In some scenarios, pump power of the first Raman pump unit 2200 may be low (where a small quantity of pump light sources are required) and pump power of the second Raman pump unit 2500 may be high (where a large quantity of pump light sources are required). In some other scenarios, the pump power of the first Raman pump unit may be high and the pump power of the second Raman pump unit may be low. In different scenarios, the target pump array provides pump light sources for the two Raman pump units, so that corresponding quantities of pump light sources can be flexibly allocated to the two pump units, thereby reducing a total quantity of pump light sources (pump lasers) in the optical amplifier 2000, and improving reliability of a structure of the optical amplifier 2000.

Optionally, the gain adjustment method provided in embodiments of this application may be specifically implemented by the control unit 2400 in the optical amplifier 2000. The control unit 2400 may include an overall control unit of the optical amplifier 2000, and control units of the lumped gain medium 2100, the first Raman pump unit 2200, and the second Raman pump unit 2500. This is not limited in this application. Embodiments of this application not only protect the gain adjustment method, but also protect the control unit 2400 that performs the gain adjustment method and a carrying medium that carries code corresponding to the gain adjustment method. The medium may be a computer device, a computer-readable storage medium, a computer program product, or the like. This is not limited in this application.

Embodiments shown in FIG. 2, FIG. 4, FIG. 7, FIG. 8A, FIG. 8B, and FIG. 11 describe structures of the optical amplifier 2000 according to embodiments of this application. Embodiments of this application further protect an optical communication device including the optical amplifier 2000. Optionally, the optical communication device is an optical transmit device, an optical receive device, a relay amplification device, or the like. This is not limited in this application.

The optical amplifier 2000 described in FIG. 2, FIG. 4, FIG. 7, FIG. 8A, FIG. 8B, and FIG. 11 is used in the optical communication system shown in FIG. 1, that is, the optical communication system provided in embodiments of this application. Optionally, the optical amplifier 2000 is an independent optical amplifier in an optical communication network, or an optical amplifier in an optical communication device in the optical communication system. This is not limited in this application.

It may be clearly understood by a person skilled in the art that, for the purpose of convenient and brief description, for a detailed working process of the foregoing system, apparatus, and unit, refer to a corresponding process in the foregoing method embodiments, and details are not described herein again.

In the several embodiments provided in this application, it should be understood that the disclosed system, apparatus, and method may be implemented in other manners. For example, the described apparatus embodiments are merely examples. For example, division into the units is merely logical function division and may be other division during actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electrical, mechanical, or other forms.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of embodiments.

In addition, functional units in embodiments of this application may be integrated into one processing unit, or each of the units may exist alone physically, or two or more units may be integrated into one unit. The integrated unit may be implemented in a form of hardware, or may be implemented in a form of a software functional unit.

When the integrated unit is implemented in the form of a software functional unit and sold or used as an independent product, the integrated unit may be stored in a computer-readable storage medium. Based on such an understanding, the technical solutions of this application essentially, or the part contributing to the related technology, or all or some of the technical solutions may be implemented in a form of a software product. The computer software product is stored in a storage medium and includes several instructions for instructing a computer device (which may be a personal computer, a server, or a network device) to perform all or some of the steps of the method described in embodiments of this application. The foregoing storage medium includes any medium that can store program code, such as a USB flash drive, a removable hard disk drive, a read-only memory (read-only memory, ROM), a random access memory (random access memory, RAM), a magnetic disk, or an optical disc.

## Claims

1. An optical amplifier, comprising a lumped gain medium, a first Raman pump unit, and a first multiplexer/demultiplexer, wherein
the lumped gain medium is configured to: amplify an input optical signal of the optical amplifier to obtain a target optical signal, and output the target optical signal to the first multiplexer/demultiplexer;
the first Raman pump unit is configured to: emit first Raman pump light, and output the first Raman pump light to the first multiplexer/demultiplexer, wherein the first Raman pump light is used to amplify the target optical signal; and
the first multiplexer/demultiplexer is configured to couple the target optical signal and the first Raman pump light, to obtain output light of the optical amplifier.

2. The optical amplifier according to claim 1, wherein the optical amplifier further comprises a control unit, and the control unit is configured to:
set the lumped gain medium to be in an output optical power locking mode, and set output optical power of the lumped medium to first power, wherein the first power is less than or equal to saturated output power of the lumped gain medium;
control the first Raman pump unit to be turned on, so that the first Raman pump unit emits the first Raman pump light; and
lock a gain of the lumped gain medium to a current gain if a target condition is met, wherein the target condition comprises: all Raman light sources from a previous relay node of the optical amplifier to the optical amplifier have been turned on.

3. The optical amplifier according to claim 1 or 2, wherein the optical amplifier further comprises a second Raman pump unit; and
the second Raman pump unit is configured to emit second Raman pump light, wherein the second Raman pump light is used to amplify an upstream optical signal of the optical amplifier, to obtain the input optical signal.

4. The optical amplifier according to claim 3, wherein the optical amplifier comprises a target pump array; and
both a light source of the first Raman pump unit and a light source of the second Raman pump unit are the target pump array.

5. The optical amplifier according to any one of claims 1 to 4, wherein the lumped gain medium comprises a semiconductor optical amplifier SOA or a gain medium doped with a rare earth element.

6. An optical communication device, comprising the optical amplifier according to any one of claims 1 to 5.

7. An optical communication system, comprising the optical amplifier according to any one of claims 1 to 5.

8. A gain adjustment method, applied to an optical amplifier, wherein the optical amplifier comprises a lumped gain medium, a first Raman pump unit, and a first multiplexer/demultiplexer; the first multiplexer/demultiplexer is configured to: couple a target optical signal amplified by the lumped gain medium and first Raman pump light emitted by the first Raman pump unit for output from the optical amplifier, and the method comprises:
setting the lumped gain medium to be in an output optical power locking mode, and setting output optical power of the lumped gain medium to first power, wherein the first power is less than or equal to saturated output power of the lumped gain medium;
turning on the first Raman pump unit to emit the first Raman pump light; and
locking a gain of the lumped gain medium to a current gain if a target condition is met, wherein the target condition comprises: all Raman light sources from a previous relay node of the optical amplifier to the optical amplifier have been turned on.

9. The method according to claim 8, wherein turning on the first Raman pump unit to emit the first Raman pump light comprises:
determining first pump power of the first Raman pump unit, wherein the first pump power is less than target power, the target power is minimum pump power that causes an optical signal to generate nonlinear noise on a target link, and the target link is a link between the optical amplifier and a next optical amplifier of the optical amplifier; and
turning on the first Raman pump unit to emit the first Raman pump light at the first pump power.

10. The method according to claim 8 or 9, wherein the optical amplifier further comprises a second Raman pump unit; and
after turning on the first Raman pump unit, the method further comprises:
if power of an input optical signal is less than a first threshold, turning on the second Raman pump unit to emit second Raman pump light, wherein the second Raman pump light is used to amplify an upstream optical signal of the optical amplifier, to increase the power of the input optical signal.

11. The method according to claim 10, wherein turning on the second Raman pump unit to emit the second Raman pump light comprises:
determining a target gain of the second Raman pump unit, wherein the target gain is a difference between saturated pump power of the second Raman pump unit and the power of the input optical signal; and
turning on the second Raman pump unit, setting the second Raman pump unit to be in a gain locking mode, and setting a gain value of the second Raman pump unit to the target gain, to emit the second Raman pump light based on the target gain.

12. The method according to claim 10 or 11, wherein locking the gain of the lumped gain medium to the current gain if the target condition is met comprises:
after turning on the second Raman pump unit, locking the gain of the lumped gain medium to the current gain if the target condition is met.

13. A computer device, comprising a processor, a memory, and a bus, wherein
the processor and the memory are connected to the bus; and
the processor is configured to perform the method according to any one of claims 8 to 12.

14. A computer-readable storage medium, wherein the computer-readable storage medium stores a program, and when a computer executes the program, the method according to any one of claims 8 to 12 is performed.

15. A computer program product, wherein when the computer program product is executed on a computer, the computer performs the method according to any one of claims 8 to 12.
